# EUROPÄISCHE PATENTANMELDUNG

(11) **EP 3 772 824 A1**
(43) Veröffentlichungstag der Anmeldung: **10.02.2021**
(21) Anmeldenummer: 20184856.1
(22) Anmeldetag: 09.07.2020
(51) Int. Cl.: H03K 17/96, G06F 3/041, G06F 3/044

(54) **VERFAHREN ZUR HERSTELLUNG EINES KAPAZITIVEN TOUCH-BEDIENELEMENTS UND KAPAZITIVES TOUCH-BEDIENELEMENT**

(30) Priorität: 08.08.2019 DE 102019121394
(71) Anmelder: Miele & Cie. KG, 33332 Gütersloh (DE)
(72) Erfinder: Schneider, Daniel, 33415 Verl (DE)

(57) **Zusammenfassung**

Die Erfindung betrifft ein Verfahren zur Herstellung eines kapazitiven Touch-Bedienelements, aufweisend die Schritte Bereitstellen eines Substrats (1); Aufbringen einer ersten transparenten leitfähigen Beschichtung (2) mit einer spaltenartigen Geometrie auf das Substrat (1); vollflächiges Aufbringen einer elektrischen Isolationsschicht (3) auf die erste transparente leitfähige Beschichtung (2); Aufbringen einer zweiten transparenten leitfähigen Beschichtung (4) mit einer zeilenartigen Geometrie auf die Isolationsschicht (3) auf eine von der ersten transparenten leitfähigen Beschichtung (2) abgewandten Seite der Isolationsschicht (3); und Kontaktieren der ersten transparenten leitfähigen Beschichtung (2) und der zweiten transparenten leitfähigen Beschichtung (4) mit Leiterbahnen (5). Ferner betrifft die Erfindung ein kapazitives Touch-Bedienelement, aufweisend ein Substrat (1) mit einem darauf angeordneten Schichtpaket aufweisend eine erste transparente leitfähige Beschichtung (2) mit einer spaltenartigen Geometrie, die auf dem Substrat (1) angeordnet ist; eine elektrische Isolationsschicht (3), die auf einer von dem Substrat (1) abgewandten Seite der ersten transparenten leitfähigen Beschichtung (2) vollflächig angeordnet ist; eine zweite transparente leitfähige Beschichtung (4) mit einer zeilenartigen Geometrie, die auf einer von der ersten transparenten leitfähigen Beschichtung (2) abgewandten Seite der Isolationsschicht (3) angeordnet ist; und Leiterbahnen (5), die die erste transparente leitfähige Beschichtung (2) und die zweite transparente leitfähige Beschichtung (4) kontaktieren.

## Beschreibung

Die Erfindung betrifft ein Verfahren zur Herstellung eines kapazitiven Touch-Bedienelements und ein kapazitives Touch-Bedienelement. Kapazitive Touch-Bedienelemente weisen üblicherweise zwei miteinander verklebte Dünngläser auf, wobei beide Dünnglaser mit einer elektrisch leitfähigen Beschichtung versehen sind, die teilweise optisch transparent und oberflächen-strukturiert ausgebildet ist. Zwischen den beiden Dünngläsern befindet sich ein isolierendes Dielektrikum zum Beispiel in Form eines Klebstoffs.

Diese räumliche und galvanische Trennung der beiden beschichteten Seiten der Dünngläser ermöglicht das Verwenden eines matrizierten Layouts für die kapazitiven Elektrodenflächen auf den Dünngläsern, das sich aus einer Vielzahl zeilen- und spaltenartiger Beschichtungsabschnitte zusammensetzt. Die so gebildeten Zeilen und Spalten sind üblicherweise um 90° zueinander verdreht angeordnet.

Das beschriebene, auf den zwei Dünngläsern basierende, kapazitive Touch-Bedienelement ist aufgrund des erforderlichen Materialaufwands sowie vieler zur Herstellung benötigter Verfahrensschritte kostenintensiv.

Weiterhin beschreibt US 8,605,050 B2 ein Aufbaukonzept für ein kapazitives Touch-Bedienelement, das durch partielles Isolieren bestimmter Bereiche der Matrix (z.B. Kreuzungspunkte) auf nur einem Glassubstrat realisiert werden kann. Mit einem nachfolgenden Verfahrensschritt zur Herstellung werden dann die unterbrochenen Zeilen oder Spalten dieser auf nur einem Substrat realisierten Matrix wieder miteinander verbunden, z.B. durch kleine Leiterbahnelemente, die als Brücken wirken. Doch auch dieser Aufbau ist kostenintensiv. Weiterhin stellen die beschriebenen Brückenelemente in den Kreuzungsbereichen der Matrix eine negative Beeinflussung der optischen Eigenschaften dar. Je nach verwendeter Technologie werden diese Brücken mittels metallischer Strukturen aufgebracht und sind somit sichtbar bzw. können die Darstellung eines dahinter angeordneten Displays negativ beeinflussen.

Der Erfindung stellt sich somit das Problem, ein Verfahren zur Herstellung eines kapazitiven Touch-Bedienelements und ein kapazitives Touch-Bedienelement bereitzustellen, die kostengünstiger sind und über homogenere optische Eigenschaften verfügen.

Erfindungsgemäß wird dieses Problem durch ein Verfahren mit den Merkmalen des Patentanspruchs 1 und ein Bedienelement mit den Merkmalen des Patentanspruchs 7 gelöst.

Vorteilhafte Ausgestaltungen und Weiterbildungen der Erfindung ergeben sich aus den nachfolgend erläuterten Unteransprüchen.

Die mit der Erfindung erreichbaren Vorteile bestehen darin, dass sie ein kostengünstiges Verfahren und ein kostengünstiges Bedienelement mit homogenen optischen Eigenschaften bereitstellt.

Die Erfindung betrifft ein Verfahren zur Herstellung eines kapazitiven Touch-Bedienelements mit einem Substrat und einem auf dem Substrat angeordneten Schichtpaket, aufweisend die Schritte
- Bereitstellen eines Substrats;
- Aufbringen einer ersten transparenten leitfähigen Beschichtung mit einer spaltenartigen Geometrie auf das Substrat;
- vollflächiges Aufbringen einer elektrischen Isolationsschicht auf die erste transparente leitfähige Beschichtung;
- Aufbringen einer zweiten transparenten leitfähigen Beschichtung mit einer zeilenartigen Geometrie auf die Isolationsschicht auf eine von der ersten transparenten leitfähigen Beschichtung abgewandten Seite der Isolationsschicht; und
- Kontaktieren der ersten transparenten leitfähigen Beschichtung mit Leiterbahnen und
- Kontaktieren der zweiten transparenten leitfähigen Beschichtung mit Leiterbahnen.

Der Schritt des Aufbringens der ersten transparenten, leitfähigen Beschichtung kann das direkte Aufbringen mit einer spaltenartigen Geometrie, etwa mittels einer Maske oder eines Druckprozesses umfassen. Alternativ kann der Schritt des Aufbringens der ersten transparenten, leitfähigen Beschichtung das Aufbringen zuerst ohne die spaltenartige Geometrie - beispielsweise vollflächig - und ein anschließendes Strukturieren zum Erhalten der spaltenartigen Geometrie umfassen.

Der Schritt des Aufbringens der zweiten transparenten, leitfähigen Beschichtung kann das direkte Aufbringen mit einer zeilenartigen Geometrie, etwa mittels einer Maske oder eines Druckprozesses umfassen. Alternativ kann der Schritt des Aufbringens der ersten transparenten, leitfähigen Beschichtung das Aufbringen zuerst ohne die zeilenartige Geometrie - beispielsweise vollflächig - und ein anschließendes Strukturieren zum Erhalten der zeilenartigen Geometrie umfassen.

Das Kontaktieren der zweiten transparenten leitfähigen Beschichtung mit Leiterbahnen kann ein (einziger) Prozessschritt sein.

Die erste transparente leitfähige Beschichtung und zweite transparente leitfähige Beschichtung werden in diesem Verfahren getrennt voneinander aufgebracht.

Bevorzugt wird in dem Verfahren nur ein einziges Substrat bereitgestellt; und nur ein einziges Substrat verwendet. Der Einsatz weiterer Substrate ist nicht notwendig und nicht erwünscht. Im Sinne der Erfindung wird unter dem Ausdruck "Substrat" ein zu beschichtendes Ausgangsmaterial mit einer derartigen Materialstärke verstanden, dass das Substrat als solches, besteht es nun aus einem Kunststoff oder aus Glas, manipulierbar und industriell prozessierbar ist. Üblicherweise wird es Dicken größer 0,05 mm aufweisen. Dies hängt letztlich jedoch von den Rahmenbedingungen ab, unter denen es zum Einsatz kommen soll. Das Substrat ist somit das flächige, transparente Ausgangsmaterial, das mit dem Schichtpaket versehen wird, das die vorstehend genannten Schichten aufweist.

Bei dem Verfahren werden die erste transparente leitfähige Beschichtung mit der spaltenartigen Geometrie und die zweite transparente leitfähige Beschichtung mit der zeilenartigen Geometrie derart aufgebracht, dass ein matriziertes Layout gebildet wird, das sich aus einer Vielzahl von Zeilen und Spalten zusammensetzt, die um 90° zueinander verdreht angeordnet sind. Grundsätzlich können mit dem beschriebenen Verfahren auch weitere Layout-Anordnungen alternativ zur Matrixanordnung verwendet werden.

Die erste transparente leitfähige Beschichtung, die transparente Isolationsschicht und die zweite transparente leitfähige Beschichtung werden bevorzugt jeweils flächig aufgebracht. Je nach Auslegung kann es sich dabei um Dünnschichten mit Schichtstärken unter einem Mikrometer oder um "Dickschichten" mit Schichtdicken über einem Mikrometer handeln. Grundsätzlich kommen eine Vielzahl möglicher Herstellungsprozesse wie Sputterprozesse / Metallisierungsprozesse (PVD), Druckprozesse etc. für das Aufbringen dieser Schichten in Frage.

Als vollflächiges Aufbringen der elektrischen Isolationsschicht im Sinne der vorliegenden Erfindung gilt eine Abdeckung der ersten transparenten leitfähigen Beschichtung, die mehr als 95% der elektrischen Beschichtung abdeckt. Die Isolationsschicht ist vollkommen frei von Unterbrechungen bzw. Öffnungen. Die kleiner 5% der ersten elektrischen Schicht, die nicht von der Isolationsschicht abgedeckt ist, befindet sich im Randbereich.

In einer bevorzugten Ausführungsform bleibt daher nach dem Aufbringen der Isolationsschicht auf die erste transparente leitfähige Beschichtung ein Rand der ersten transparenten leitfähigen Beschichtung von der Isolationsschicht unbedeckt. Dadurch wird das Kontaktieren der ersten transparenten leitfähigen Beschichtung und der zweiten transparenten leitfähigen Beschichtung mittels Aufbringens einer einzelnen Lage an Leiterbahnen auf die erste transparente leitfähige Beschichtung und auf die zweite transparente leitfähige Beschichtung durchgeführt. Daher ist zur Herstellung des kapazitiven Touch-Bedienelements bei dieser bevorzugten Variante nur eine einzige, bevorzugt in einem Verfahrensschritt herstellbare, Leiterbahn-Lage notwendig, wodurch Material- und Verfahrenskosten eingespart werden können.

Bevorzugt wird als Isolationsschicht ein Dünnschicht-Dielektrikum verwendet. Bevorzugt kommt als Substrat ein Glas oder Kunststoff zum Einsatz. Der Kunststoff kann beispielsweise PET (Polyethylenterephthalat) sein. Bevorzugter wird als Substrat Glas insbesondere Dünnglas eingesetzt. Bevorzugt werden als erste transparente leitfähige Beschichtung und/oder zweite transparente leitfähige Beschichtung TCO (transparent conductive oxide, transparentes elektrisches leitfähiges Oxid) verwendet. TCOs sind beispielsweise ITO (Indium-Zinn-Oxid), FTO (Fluor-Zinn-Oxid, AZO (Aluminium-Zink-Oxid) und ATO (Antimon-Zinn-Oxid). Bevorzugter wird als Material für die erste transparente leitfähige Beschichtung und die zweite transparente leitfähige Beschichtung ITO verwendet.

Alternativ zu den genannten TCO-Beschichtungen können leitfähige Materialen auf Basis von Nanopartikeln wie z.B. Ag-Nanowire, Cu-Nanowire, Au-Nanowire (...), CNT (englisch carbon nanotubes), CNB (englisch carbon nanobuds) sowie z.B. Materialien auf Basis von PEDOT (Poly-3,4-ethylendioxythiophen) verwendet werden.

In einer bevorzugten Ausführungsform werden weiterhin eine oder mehrere Schutzschichten überdeckend das Schichtpaket der ersten transparenten leitfähigen Beschichtung, der Isolationsschicht der zweiten transparenten leitfähigen Beschichtung und der Leiterbahnen angeordnet. Als Schutzschicht(en) wird(werden) beispielsweise ein Isolierlack, SiO₂ (Siliziumdioxid) oder dgl. eingesetzt.

Bevorzugt wird das Kontaktieren der ersten transparenten leitfähigen Beschichtung und der zweiten transparenten leitfähigen Beschichtung mit Leiterbahnen mittels Bedruckung und/oder Metallisierung der ersten transparenten leitfähigen Beschichtung und der zweiten transparenten leitfähigen Beschichtung realisiert. Als Material für die Leiterbahn können alle elektrisch leitfähigen Materialien wie beispielsweise Silber, Gold, Kupfer, Aluminium, Molybdän etc. sowie deren Kombinationen zum Einsatz kommen.

Die Erfindung betrifft ferner ein kapazitives Touch-Bedienelement, aufweisend
- ein Substrat mit einem darauf angeordneten Schichtpaket aufweisend;
- eine erste transparente leitfähige Beschichtung mit einer spaltenartigen Geometrie, die auf dem Substrat angeordnet ist;
- eine elektrische Isolationsschicht, die auf einer von dem Substrat abgewandten Seite der ersten transparenten leitfähigen Beschichtung vollflächig angeordnet ist;
- eine zweite transparente leitfähige Beschichtung mit einer zeilenartigen Geometrie, die auf einer von der ersten transparenten leitfähigen Beschichtung abgewandten Seite der Isolationsschicht angeordnet ist; und
- Leiterbahnen, die die erste transparente leitfähige Beschichtung und die zweite transparente leitfähige Beschichtung kontaktieren.

In Bezug auf das Verfahren beschriebene Ausführungsformen und Vorteile gelten für das kapazitive Touch-Bedienelement entsprechend und umgekehrt.

Bevorzugt weist das kapazitive Touch-Bedienelement ein einziges Substrat auf. Bevorzugt ist die Isolationsschicht als Dünnschicht-Dielektrikum ausgebildet ist. Bevorzugt ist das Substrat als Glas oder Kunststoff ausgebildet. Der Kunststoff kann beispielsweise PET (Polyethylenterephthalat) sein. Bevorzugter ist das Substrat als Glas insbesondere Dünnglas ausgebildet. Bevorzugt sind die erste transparente leitfähige Beschichtung und die zweite transparente leitfähige Beschichtung aus TCO (transparent conductive oxide, transparentes elektrisches leitfähiges Oxid). TCOs sind beispielsweise ITO (Indium-Zinn-Oxid), FTO (Fluor-Zinn-Oxid, AZO (Aluminium-Zink-Oxid) und ATO (Antimon-Zinn-Oxid). Bevorzugter sind die erste transparente leitfähige Beschichtung und die zweite transparente leitfähige Beschichtung aus ITO ausgebildet.

Diese räumliche und galvanische Trennung der ersten transparenten, leitfähigen Beschichtung und der zweiten leitfähigen Beschichtung durch die Isolationsschicht ermöglicht das Verwenden des matrizierten Layouts, das sich aus einer Vielzahl von Zeilen und Spalten zusammensetzt.

Bevorzugt ist ein Rand der ersten transparenten leitfähigen Beschichtung von der Isolationsschicht unbedeckt und sind die erste transparente leitfähige Beschichtung und die zweite transparente leitfähige Beschichtung mit einer einzelnen Lage an Leiterbahnen kontaktiert sind. Dadurch werden Materialkosten eingespart und der Aufwand bei der Herstellung reduziert.

In einer bevorzugten Ausführungsform sind weiterhin eine oder mehrere Schutzschichten überdeckend das Schichtpaket der ersten transparenten leitfähigen Beschichtung, der Isolationsschicht der zweiten transparenten leitfähigen Beschichtung und der Leiterbahnen angeordnet. Als Schutzschicht(en) wird(werden) beispielsweise ein Isolierlack, SiO₂ (Siliziumdioxid) oder dgl. eingesetzt. Diese Schichten sind derart konzipiert, dass sie den Schichtstapel vor Umwelteinflüssen schützen. Zudem können die Schutzschichten einen Schutz beim Verkleben des kapazitiven Touch-Bedienelements beispielsweise vor einem aggressiven Klebstoff sicherstellen.

Ein Ausführungsbeispiel der Erfindung ist in den Zeichnungen rein schematisch dargestellt und wird nachfolgend näher beschrieben. Es zeigt
- Fig. 1: eine perspektivische Ansicht eines erfindungsgemäßen kapazitiven TouchBedienelements;
- Fig. 2: eine Draufsicht auf das in Fig. 1 gezeigte kapazitive Touch-Bedienelement; und
- Fig. 3: eine Explosionsansicht des in Fig. 1 gezeigten kapazitiven Touch-Bedienelements.

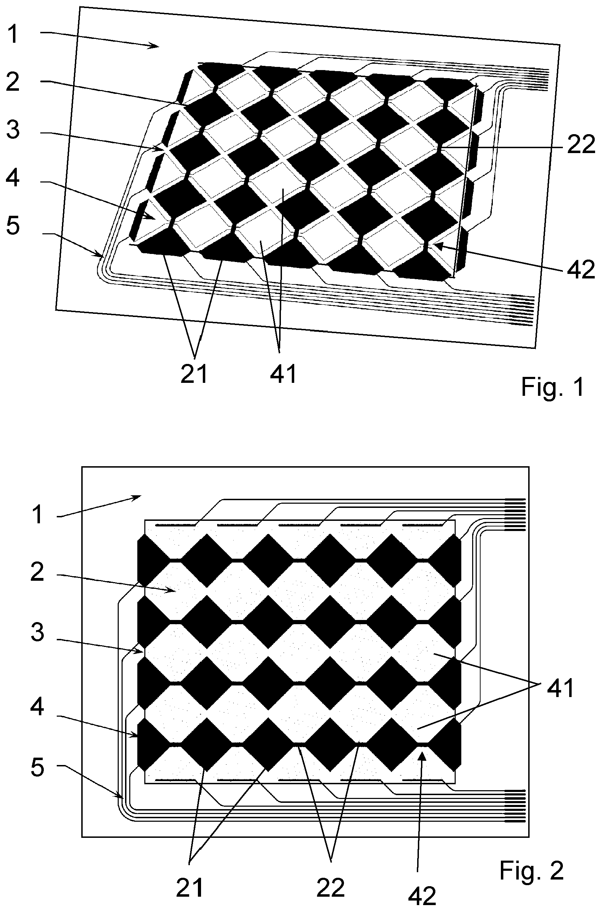

Fig. 1 zeigt eine perspektivische Ansicht eines erfindungsgemäßen kapazitiven Touch-Bedienelements. Das kapazitive Touch-Bedienelement weist ein Substrat 1 mit einem darauf angeordneten Schichtpaket auf. Das Schichtpaket weist eine erste transparente leitfähige Beschichtung 2 mit einer spaltenartigen Geometrie, eine darauf angeordnete elektrische Isolationsschicht 3, eine darauf angeordnete zweite transparente leitfähige Beschichtung 4 mit einer zeilenartigen Geometrie und Leiterbahnen 5 auf, die die erste transparente leitfähige Beschichtung 2 und die zweite transparente leitfähige Beschichtung 4 vom Randbereich her kontaktieren.

Die erste transparente leitfähige Beschichtung 2 mit der spaltenartigen Geometrie weist mehrere Spalten auf. Jede Spalte weist mehrere Spaltenelemente 21 auf, die durch stegartige Verbindungselemente 22 miteinander verbunden sind. Die zweite transparente leitfähige Beschichtung 4 mit der zeilenartigen Geometrie weist mehrere Zeilen auf. Jede Zeile weist mehrere Zeilenelemente 41 auf, die durch stegartige Verbindungselemente 42 miteinander verbunden sind. Dadurch ist ein matriziertes Layout gebildet, das sich aus einer Vielzahl von Zeilen und Spalten zusammensetzt, die um 90° zueinander verdreht angeordnet sind.

Fig. 2 zeigt eine Draufsicht auf das in Fig. 1 gezeigte kapazitive Touch-Bedienelement. Die Leiterbahnen 5 kontaktieren die erste transparente leitfähige Beschichtung 2 und die zweite transparente leitfähige Beschichtung 4.

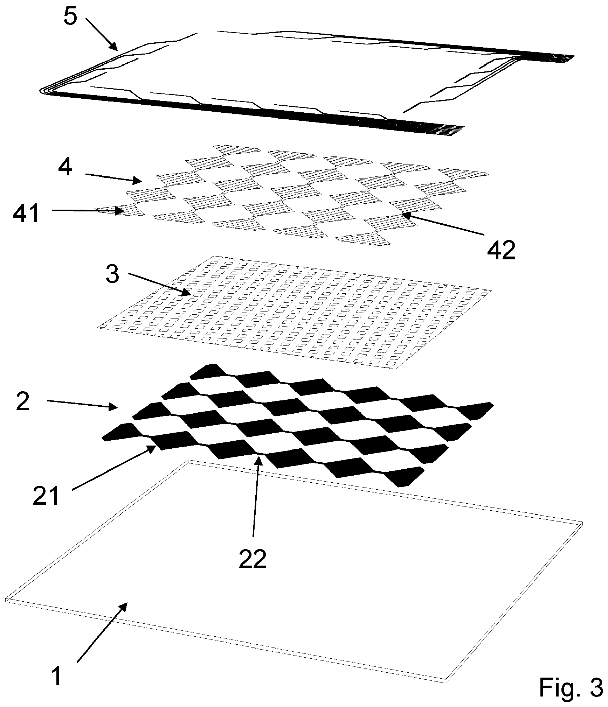

Fig. 3 zeigt eine Explosionsansicht des in Fig. 1 gezeigten kapazitiven Touch-Bedienelements. Auf dem Substrat 1 ist das Schichtpaket folgendermaßen angeordnet: Die erste transparente leitfähige Beschichtung 2 mit einer spaltenartigen Geometrie ist auf dem Substrat 1 angeordnet. Die elektrische Isolationsschicht 3 ist auf einer von dem Substrat 1 abgewandten Seite der ersten transparenten leitfähigen Beschichtung 2 vollflächig angeordnet. Vollflächig heißt, dass abgesehen von einem umlaufenden Randbereich 95% der Fläche der ersten transparenten leitfähigen Beschichtung 2 unterbrechungsfrei abgedeckt sind. Die zweite transparente leitfähige Beschichtung 4 mit einer zeilenartigen Geometrie ist auf einer von der ersten transparenten leitfähigen Beschichtung 2 abgewandten Seite der Isolationsschicht 3 angeordnet. Ein Rand der ersten transparenten leitfähigen Beschichtung 2 ist von der Isolationsschicht 3 unbedeckt, so dass die erste transparente leitfähige Beschichtung 2 und die zweite transparente leitfähige Beschichtung 4 mit einer einzelnen Lage an Leiterbahnen 5 kontaktiert sind.

Wie ersichtlich, werden alle Schichten getrennt voneinander aufgebracht. Zur Herstellung des kapazitiven Touch-Bedienelements wird zuerst das Substrat 1 bereitgestellt; dann wird die erste transparente leitfähige Beschichtung 2 mit der spaltenartigen Geometrie auf das Substrat 1 aufgebracht; dann wird die elektrische Isolationsschicht 3 auf die erste transparente leitfähige Beschichtung 2 aufgebracht; dann wird die zweite transparente leitfähige Beschichtung 4 mit der zeilenartigen Geometrie auf die Isolationsschicht 3 auf eine von der ersten transparenten leitfähigen Beschichtung 2 abgewandten Seite der Isolationsschicht 3 aufgebracht; und anschließend werden die erste transparente leitfähige Beschichtung 2 und die zweite transparente leitfähige Beschichtung 4 mit den Leiterbahnen 5 kontaktiert. Die Zeilenelemente 41 jeder Zeile und die Spaltenelemente 21 jeder Spalte sind jeweils durch die stegartige Verbindungselemente 42 bzw. 22 miteinander verbunden, die sich jeweils zwischen zwei Zeilenelementen 41 bzw. Spaltenelementen 42 befinden.

### Bezugszeichenliste

- 1: Substrat
- 2: erste transparente leitfähige Beschichtung
- 21: Spaltenelement
- 22: Verbindungselement
- 3: Isolationsschicht
- 4: zweite transparente leitfähige Beschichtung
- 41: Zeilenelement
- 42: Verbindungselement
- 5: Leiterbahn

## Patentansprüche

1. Verfahren zur Herstellung eines kapazitiven Touch-Bedienelements mit einem Substrat und einem auf dem Substrat angeordneten Schichtpaket, aufweisend die Schritte
- Bereitstellen eines Substrats (1);
- Aufbringen einer ersten transparenten leitfähigen Beschichtung (2) mit einer spaltenartigen Geometrie auf das Substrat (1);
- vollflächiges Aufbringen einer elektrischen Isolationsschicht (3) auf die erste transparente leitfähige Beschichtung (2);
- Aufbringen einer zweiten transparenten leitfähigen Beschichtung (4) mit einer zeilenartigen Geometrie auf die Isolationsschicht (3) auf eine von der ersten transparenten leitfähigen Beschichtung (2) abgewandten Seite der Isolationsschicht (3); und
- Kontaktieren der ersten transparenten leitfähigen Beschichtung (2) mit Leiterbahnen (5) und
- Kontaktieren der zweiten transparenten leitfähigen Beschichtung (4) mit Leiterbahnen (5).

2. Verfahren nach Anspruch 1, **dadurch gekennzeichnet, dass**
- beim Aufbringen der Isolationsschicht (3) auf die erste transparente leitfähige Beschichtung (2) ein Bereich am Rand der ersten transparenten leitfähigen Beschichtung (2) von der Isolationsschicht (3) unbedeckt bleibt und
- das Kontaktieren der ersten transparenten leitfähigen Beschichtung (2) und der zweiten transparenten leitfähigen Beschichtung (4) mittels Aufbringens einer einzelnen Lage an Leiterbahnen (5) auf die erste transparente leitfähige Beschichtung (2) oder zweite transparente leitfähige Beschichtung (4) durchgeführt wird.

3. Verfahren nach Anspruch 1 oder 2, **dadurch gekennzeichnet, dass** die Isolationsschicht (3) als Dünnschicht-Dielektrikum ausgebildet ist und/oder das Substrat (1) als Glas oder Kunststoff ausgebildet ist.

4. Verfahren nach einem der vorangehenden Ansprüche, **dadurch gekennzeichnet, dass** die erste transparente leitfähige Beschichtung (2) und die zweite transparente leitfähige Beschichtung (4) aus TCO (transparent conductive oxide), bevorzugt ITO (Indium-Zinn-Oxid), ausgebildet sind.

5. Verfahren nach einem der vorangehenden Ansprüche, **dadurch gekennzeichnet, dass** weiterhin eine oder mehrere Schutzschichten überdeckend das Schichtpaket der ersten transparenten leitfähigen Beschichtung (2), der Isolationsschicht (3) der zweiten transparenten leitfähigen Beschichtung (4) und der Leiterbahnen (5) angeordnet werden.

6. Verfahren nach Anspruch einem der vorangehenden Ansprüche, **dadurch gekennzeichnet, dass** das Kontaktieren der ersten transparenten leitfähigen Beschichtung (2) und der zweiten transparenten leitfähigen Beschichtung (4) mit Leiterbahnen (5) mittels Bedruckung und/oder Metallisierung der ersten transparenten leitfähigen Beschichtung (2) und der zweiten transparenten leitfähigen Beschichtung (4) realisiert wird.

7. Kapazitives Touch-Bedienelement, aufweisend
- ein Substrat (1) mit einem darauf angeordneten Schichtpaket aufweisend
- eine erste transparente leitfähige Beschichtung (2) mit einer spaltenartigen Geometrie, die auf dem Substrat (1) angeordnet ist;
- eine elektrische Isolationsschicht (3), die auf einer von dem Substrat (1) abgewandten Seite der ersten transparenten leitfähigen Beschichtung (2) vollflächig angeordnet ist;
- eine zweite transparente leitfähige Beschichtung (4) mit einer zeilenartigen Geometrie, die auf einer von der ersten transparenten leitfähigen Beschichtung (2) abgewandten Seite der Isolationsschicht (3) angeordnet ist; und
- Leiterbahnen (5), die die erste transparente leitfähige Beschichtung (2) und die zweite transparente leitfähige Beschichtung (4) kontaktieren.

8. Bedienelement nach Anspruch 7, **dadurch gekennzeichnet, dass** die elektrische Isolationsschicht (3) aus Dünnschicht-Dielektrikum ausgebildet ist, das Substrat (1) aus Glas oder Kunststoff ausgebildet ist, die erste transparente leitfähige Beschichtung (2) aus TCO ausgebildet ist und/oder die zweite transparente leitfähige Beschichtung (4) aus TCO ausgebildet ist.

9. Bedienelement nach einem der Anspruch 7 oder 8, **dadurch gekennzeichnet, dass** ein Bereich am Rand der ersten transparenten leitfähigen Beschichtung (2) von der Isolationsschicht (3) unbedeckt ist und die erste transparente leitfähige Beschichtung (2) und die zweite transparente leitfähige Beschichtung (4) mit einer einzelnen Lage an Leiterbahnen (5) kontaktiert sind.

10. Bedienelement nach einem der Ansprüche 7 bis 9, **dadurch gekennzeichnet, dass** weiterhin eine oder mehrere Schutzschichten überdeckend das Schichtpaket der ersten transparenten leitfähigen Beschichtung (2), der Isolationsschicht (3) der zweiten transparenten leitfähigen Beschichtung (4) und der Leiterbahnen (5) angeordnet sind.
